(19) Europäisches Patentamt / European Patent Office / Office européen des brevets

(11) **EP 4 293 735 A1**

(12) **EUROPEAN PATENT APPLICATION**
published in accordance with Art. 153(4) EPC

(43) Date of publication:
**20.12.2023 Bulletin 2023/51**

(21) Application number: **22752505.2**

(22) Date of filing: **12.01.2022**

(51) International Patent Classification (IPC):
*H01L 41/047* (2006.01)    *H01L 41/053* (2006.01)
*H01L 41/09* (2006.01)    *H01L 41/113* (2006.01)
*H01L 41/187* (2006.01)    *H01L 41/23* (2013.01)
*H01L 41/29* (2013.01)

(52) Cooperative Patent Classification (CPC):
**H10N 30/02; H10N 30/06; H10N 30/20;**
**H10N 30/30; H10N 30/853; H10N 30/87;**
**H10N 30/88**

(86) International application number:
**PCT/JP2022/000632**

(87) International publication number:
**WO 2022/172672 (18.08.2022 Gazette 2022/33)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **12.02.2021 JP 2021021088**

(71) Applicant: **Sumitomo Chemical Company Limited**
**Tokyo 103-6020 (JP)**

(72) Inventors:
• **KURODA Toshiaki**
**Hitachi-shi, Ibaraki 319-1418 (JP)**
• **SHIBATA Kenji**
**Hitachi-shi, Ibaraki 319-1418 (JP)**
• **WATANABE Kazutoshi**
**Hitachi-shi, Ibaraki 319-1418 (JP)**
• **KIMURA Takeshi**
**Hitachi-shi, Ibaraki 319-1418 (JP)**

(74) Representative: **Vossius & Partner**
**Patentanwälte Rechtsanwälte mbB**
**Siebertstraße 3**
**81675 München (DE)**

(54) **PIEZOELECTRIC LAMINATE, PIEZOELECTRIC ELEMENT, AND METHOD FOR MANUFACTURING PIEZOELECTRIC LAMINATE**

(57) There is provided a piezoelectric stack including: a substrate (1); a bottom electrode film (2) on the substrate; a piezoelectric film (3) on the bottom electrode film, having a planar area smaller than a planar area of the bottom electrode film; a top electrode film (4) on the piezoelectric film; and an insulating film (5) provided from the top electrode film to the bottom electrode film and covering at least a part of a side surface of the piezoelectric film, wherein the insulating film has a slope (9a) filling a step between a top surface of the top electrode film and a top surface of the bottom electrode film, and the slope has a shape alleviating the step.

EP 4 293 735 A1

# FIG. 1

(a)

(b)

**Description**

TECHNICAL FIELD

The present disclosure relates to a piezoelectric stack, a piezoelectric element, and a method of manufacturing a piezoelectric stack.

DESCRIPTION OF RELATED ART

Piezoelectric materials are widely utilized in functional electronic components such as sensors and actuators. Widely used piezoelectric materials include lead-based materials, particularly PZT-based ferroelectrics represented by a composition formula $Pb(Zr_{1-x}Ti_x)O_3$. PZT-based piezoelectric materials comprise lead and thus are not preferable from a viewpoint of pollution prevention and the like. For this reason, the piezoelectric materials comprising potassium, sodium, niobium, and oxygen is proposed as a piezoelectric material not comprising lead, and a stack having a piezoelectric film deposited using such a piezoelectric material (hereinafter referred to as piezoelectric stack) is also proposed (see, e.g., Patent Documents 1 and 2).

PRIOR ART DOCUMENT

PATENT DOCUMENT

    Patent Document 1: Japanese Patent Laid Open Publication No. 2007-184513
    Patent Document 2: Japanese Patent Laid Open Publication No. 2008-159807

SUMMARY

PROBLEM TO BE SOLVED BY DISCLOSURE

The present disclosure has an object to improve a reliability of a piezoelectric element or piezoelectric device module produced using a piezoelectric stack.

MEANS FOR SOLVING PROBLEM

According to an aspect of the present disclosure, there are provided a piezoelectric stack and its related techniques, including:

    a substrate;
    a bottom electrode film on the substrate;
    a piezoelectric film on the bottom electrode film, having a planar area smaller than a planar area of the bottom electrode film;
    a top electrode film on the piezoelectric film; and
    an insulating film provided from the top electrode film to the bottom electrode film and covering at least a part of a side surface of the piezoelectric film,
    wherein the insulating film has a slope filling a step between a top surface of the top electrode film and a top surface of the bottom electrode film, and
    the slope has a shape alleviating the step.

ADVANTAGE OF DISCLOSURE

According to the present disclosure, the reliability of the piezoelectric element or piezoelectric device module produced using the piezoelectric stack can be improved.

BRIEF DESCRIPTION OF DRAWINGS

3

FIG. 1(a) is a view illustrating an example of a cross-sectional structure of a piezoelectric stack according to an embodiment of the present disclosure, and FIG. 1(b) is a view illustrating an example of a top view of the piezoelectric stack illustrated in FIG. 1(a).

FIG. 2 is a view illustrating a modified example of the cross-sectional structure of the piezoelectric stack according to the embodiment of the present disclosure.

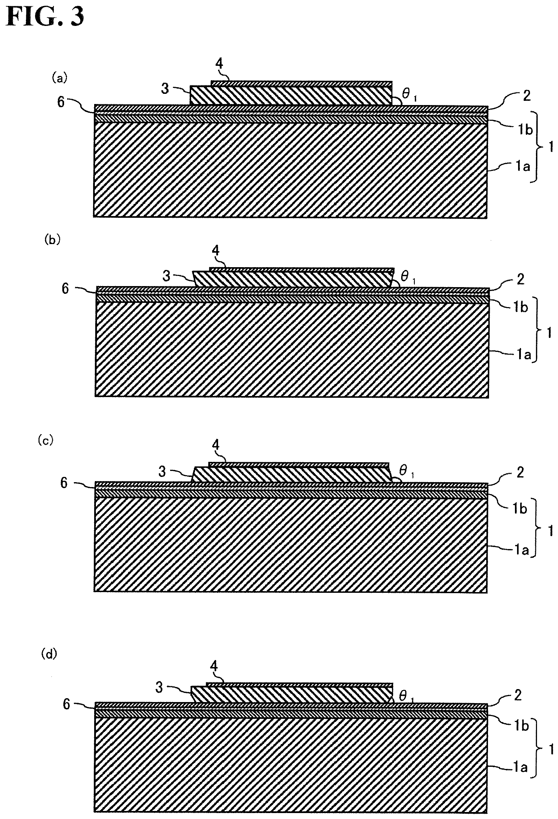

FIGS. 3 are views exemplifying a state of a side surface of the piezoelectric film in the piezoelectric stack according to the embodiment of the present disclosure, in which FIG. 3(a) is a view illustrating an example where the side surface of the piezoelectric film is perpendicular to a top surface of a bottom electrode film, FIG. 3(b) is a view illustrating an example where the side surface of the piezoelectric film is an inclined surface inclined at a predetermined angle relative to the top surface of the bottom electrode film, FIG. 3(c) is a view illustrating another example where the side surface of the piezoelectric film is an inclined surface inclined at a predetermined angle relative to the top surface of the bottom electrode film, and FIG. 3(d) is a view illustrating an example where at least a bottom electrode film-side surface of the side surfaces of the piezoelectric film is an inclined surface inclined at a predetermined angle, and a surface excluding at least the bottom electrode film-side surface of the side surfaces of the piezoelectric film is perpendicular to the top surface of the bottom electrode film.

FIGS. 4 are explanatory views of an inclination angle $\theta_2$ of a first slope in the piezoelectric stack according to the embodiment of the present disclosure, in which FIG. 4(a) is a view illustrating an example where the inclination angle $\theta_2$ is smaller than that in the example illustrated in FIG. 1(a), and FIG. 4(b) is a view illustrating an example where the inclination angle $\theta_2$ is larger than that in the example illustrated in FIG. 1(a).

FIG. 5 is a view illustrating an example of a schematic configuration of a piezoelectric device module according to an embodiment of the present disclosure.

FIG. 6(a) is a view illustrating an example of the cross-sectional structure of the piezoelectric stack according to the embodiment of the present disclosure, and FIG. 6(b) shows an SEM image of an area indicated by a dotted line A in FIG. 6(a).

FIG. 7(a) is a view illustrating an example of the cross-sectional structure of the piezoelectric stack according to the embodiment of the present disclosure, FIG.7(b) shows an SEM image of an area indicated by a dotted line B in FIG. 7(a), FIG.7(c) shows an enlarged SEM image of an area indicated by a dotted line C in FIG. 7(b), FIG. 7(d) shows an enlarged SEM image of an area indicated by a dotted line D in FIG. 7(b), and FIG. 7(e) shows an enlarged SEM image of an area indicated by a dotted line E in FIG. 7(b).

FIG. 8 is a view illustrating a modified example of the cross-sectional structure of the piezoelectric stack according to the embodiment of the present disclosure.

FIG. 9 is a view illustrating another modified example of the cross-sectional structure of the piezoelectric stack according to the embodiment of the present disclosure.

FIG. 10(a) is a view illustrating another modified example of the cross-sectional structure of the piezoelectric stack according to the embodiment of the present disclosure, and FIG. 10(b) is a view illustrating an example of a top view of the piezoelectric stack illustrated in FIG. 10(a).

FIG. 11 is a view illustrating an example of a cross-sectional structure of a conventional piezoelectric stack.

FIG. 12 is a view illustrating a comparative example with regard to the cross-sectional structure of the piezoelectric stack according to the embodiment of the present disclosure.

DETAILED DESCRIPTION OF THE DISCLOSURE

<Embodiment of the Present Disclosure>

Hereinafter, an embodiment of the present disclosure will be described with reference to the drawings.

(1) Configuration of piezoelectric stack

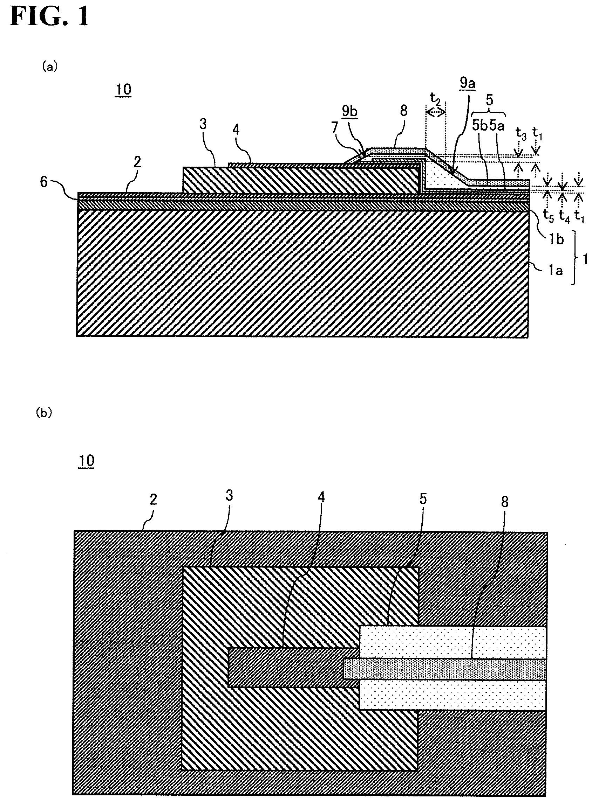

As illustrated in FIGS. 1(a) and 1(b), a stack 10 (hereinafter also referred to as a piezoelectric stack 10) including a piezoelectric film according to the present embodiment includes a substrate 1, a bottom electrode film 2 on the substrate 1, a piezoelectric film (piezoelectric thin film) 3 on the bottom electrode film 2, a top electrode film 4 on the piezoelectric film 3, and an insulating film 5. In this embodiment, a description will be given, as an example, of a case where one stack structure (a structure comprising a stack of at least the bottom electrode film 2, the piezoelectric film 3, the top electrode film 4, and the insulating film 5) is provided on one substrate 1.

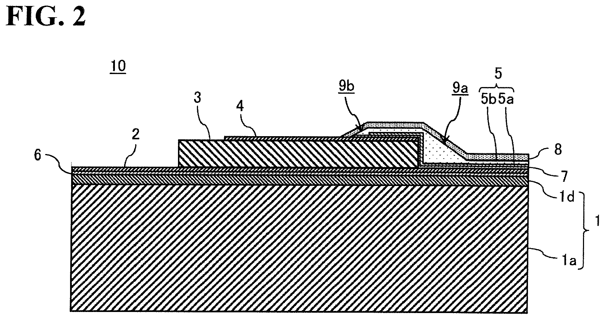

The substrate 1 can be suitably a monocrystalline silicon (Si) substrate 1a on which a surface oxide film (SiO$_2$-film) 1b such as a thermal oxide film or chemical vapor deposition (CVD) oxide film is formed, i.e., a Si-substrate having a surface oxide film. Alternatively, as illustrated in FIG. 2, the substrate 1 can be a Si-substrate 1a having an insulating film 1d formed on a surface thereof, the insulating film 1d comprising an insulating material other than SiO$_2$.

Alternatively, the substrate 1 can be a Si-substrate la in which Si-(100), Si-(111), or the like, is exposed on the surface thereof, i.e., a Si-substrate not having the surface oxide film 1b or insulating film 1d. The substrate 1a can also be an SOI (Silicon On Insulator) substrate, a quartz glass ($SiO_2$) substrate, a gallium arsenide (GaAs) substrate, a sapphire ($Al_2O_3$) substrate, or a metal substrate comprising a metal material such as stainless steel (SUS). A thickness of the monocrystalline Si-substrate 1a can be, for example, 300 $\mu$m or more and 1000 $\mu$m or less, and a thickness of the surface oxide film 1b can be, for example, 1 nm or more and 4000 nm or less.

The bottom electrode film 2 can be deposited using, for example, platinum (Pt). The bottom electrode film 2 can be a polycrystalline film or a monocrystalline film (hereinafter collectively also referred to as Pt-film). Preferably, most of crystals constituting the Pt-film have (111) parallel to a main surface of the substrate 1 (including a crystal whose (111) is inclined at an angle within $\pm5°$ relative to the main surface of the substrate 1), i.e., the crystals constituting the Pt-film are preferentially oriented in (111) direction. The meaning of : the crystals constituting the Pt-film are preferentially oriented in (111) direction in an X-ray diffraction pattern obtained by X-ray diffraction (XRD) measurement, is that a peak due to (111) is the highest. In other words, a top surface of the bottom electrode film 2 (a surface to be a base of the piezoelectric film 3) is preferably mainly composed of Pt-(111). The bottom electrode film 2 can be deposited by a sputtering method, an evaporation method, or the like. The bottom electrode film 2 can also be deposited using, in place of Pt, various metals such as gold (Au), ruthenium (Ru), or iridium (Ir); alloys comprising these metals as main components; metal oxides such as strontium ruthenium oxide ($SrRuO_3$, abbreviated as SRO) or lanthanum nickel oxide ($LaNiO_3$, abbreviated as LNO); or the like. The bottom electrode film 2 can also be a monolayer film deposited using the above-described various metals, metal oxides, or the like. The bottom electrode film 2 can also be a stack including a Pt-film and a film comprising SRO provided on the Pt-film, a stack including a Pt-film and a film comprising LNO provided on the Pt-film, or the like. An adhesion layer 6 mainly comprising, for example, titanium (Ti), tantalum (Ta), titanium oxide ($TiO_2$), nickel (Ni), ruthenium oxide ($RuO_2$), iridium oxide ($IrO_2$), zinc oxide (ZnO), or the like may also be provided between the substrate 1 and the bottom electrode film 2 in order to enhance an adhesion between them. The adhesion layer 6 can be deposited by a method such as the sputtering method or an evaporation method. A thickness of the bottom electrode film 2 (a total thickness of respective layers, when the bottom electrode film 2 is a stack) can be, for example, 100 nm or more and 400 nm or less, and a thickness of the adhesion layer 6 can be, for example, 1 nm or more and 200 nm or less.

The piezoelectric film 3 comprises a material with etching anisotropy. The piezoelectric film 3 is an alkali niobium oxide film comprising, for example, potassium (K), sodium (Na), niobium (Nb), and oxygen (O). The piezoelectric film 3 can be deposited using potassium sodium niobium oxide (KNN). The piezoelectric film 3 is a polycrystalline film of KNN (hereinafter also referred to as KNN-film 3). A crystal structure of KNN is a perovskite structure. In other words, the KNN-film 3 has the perovskite structure. The KNN-film 3 can be deposited by a method such as the sputtering method, a PLD (Pulsed Laser Deposition) method, or a sol-gel method. A thickness of the KNN-film 3 can be, for example, 0.5 $\mu$m or more and 5 $\mu$m or less.

The KNN-film 3 may comprise an element(s) other than K, Na, Nb, and O, such as copper (Cu), manganese (Mn), lithium (Li), tantalum (Ta), or antimony (Sb) within a range of, for example, 5 at% or less (when a plurality kinds of the above-described elements are added, a total concentration thereof being 5 at% or less).

Preferably, crystals constituting the KNN-film 3 are preferentially oriented in (001) direction relative to the main surface of the substrate 1 (or the Si-substrate 1a when the substrate 1 is, for example, the Si-substrate 1a having the surface oxide film 1b or insulating film 1d). That is, a top surface of the KNN-film 3 (a surface to be a base of the top electrode film 4) is preferably mainly composed of KNN-(001). For example, by depositing the KNN-film 3 directly on the Pt-film (bottom electrode film 2) whose top surface is mainly composed of Pt-(111), the KNN-film 3 whose top surface is mainly composed of KNN-(001) can be easily obtained.

In this specification, the meaning of the crystals constituting the KNN-film 3 are oriented in (001) direction, is that (001) of the crystals constituting the KNN-film 3 is parallel to the main surface of the substrate 1. The meaning of (001) of the crystals constituting the KNN-film 3 is parallel to the main surface of the substrate 1, includes a case where (001) is completely parallel to the main surface of the substrate 1, as well as a case where (001) is inclined within $\pm5°$, preferably $\pm3°$, relative to the main surface of the substrate 1. The meaning of: the crystals constituting KNN-film 3 are preferentially oriented in (001) direction, is that most of the crystals are parallel to the main surface of the substrate 1. For example, 80 % or more crystals in a crystal group constituting the KNN-film 3 are preferably oriented in (001) direction relative to the main surface of the substrate 1. That is, a (001) orientation ratio of the crystals constituting the KNN-film 3 is preferably, for example, 80 % or more, and more preferably 90 % or more. The "orientation ratio" in this specification is a value calculated by the following (Math. 1) based on a peak intensity of an X-ray diffraction pattern ($2\theta/\theta$) obtained by XRD measurement on the KNN-film 3.

(Math. 1)

$$\text{Orientation ratio (\%)} = \{(001) \text{ diffraction peak intensity} / ((001) \text{ diffraction peak intensity} + (110) \text{ diffraction peak intensity})\} \times 100$$

The "(001) diffraction peak" in the above (Math. 1) and this specification is a diffraction peak due to crystals oriented in (001) direction (i.e., a crystal whose (001) is parallel to the main surface of the substrate 1) of the crystals constituting the KNN-film 3 in the X-ray diffraction pattern obtained by XRD measurement on the KNN-film 3, and is a peak which appears within a range that 20 is 20° or more and 23° or less. The "(110) diffraction peak" in the above (Math. 1) and this specification is a diffraction peak due to crystals oriented in (110) direction (i.e., a crystal whose (110) is parallel to the main surface of the substrate 1) of the crystals constituting the KNN-film 3 in the X-ray diffraction pattern obtained by XRD measurement on the KNN-film 3, and is a peak which appears within a range that 20 is 30° or more and 33° or less.

Half or more crystals in the crystal group constituting the KNN-film 3 preferably have a columnar structure. Boundaries between the crystals constituting the KNN-film 3, i.e., crystal grain boundaries present in the KNN-film 3, preferably penetrate the KNN-film 3 in a thickness direction. For example, the KNN-film 3 preferably has more crystal grain boundaries that penetrate the KNN-film 3 in the thickness direction than crystal grain boundaries that do not penetrate the KNN-film 3 in the thickness direction.

The KNN-film 3 is subjected to an etching process, whereby a planar area of the KNN-film 3 is smaller than a planar area of the bottom electrode film 2. The KNN-film 3 configured as described above exhibits a predetermined etching anisotropy when being subjected to the etching process. For example, when the KNN-film 3 is subjected to wet etching through an etching mask formed on the KNN-film 3, an etching rate in a film thickness direction (growth direction) tends to become greater than that in a creeping direction (direction orthogonal to the growth direction).

Due to an influence of the above etching anisotropy, there is a tendency that a side surface of the KNN-film 3 exposed by etching is processed to be perpendicular to the top surface of the bottom electrode film 2, that at least a part of the side surface of the KNN-film 3 is processed to be an inclined surface inclined at an angle of 75° or more and less than 90°, preferably 85° or more and less than 90° relative to the top surface of the bottom electrode film 2, or that at least a part of the side surface of the KNN-film 3 is processed to be an inclined surface inclined at an angle of more than 90° and 105° or less, preferably more than 90° and 100° or less relative to the top surface of the bottom electrode film 2. That is, as illustrated in FIG. 3(a), an angle $\theta_1$ between the side surface of the KNN-film 3 and the top surface of the bottom electrode film 2 (hereinafter referred to as an "angle $\theta_1$") can be, for example, 90°. Further, as illustrated in FIG. 3(b), the angle $\theta_1$ can also be, for example, 75° or more and less than 90°, preferably 85° or more and less than 90°. Furthermore, as illustrated in FIG. 3(c), the angle $\theta_1$ can also be, for example, more than 90° and 105° or less, preferably more than 90° and 100° or less. Thus, the angle $\theta_1$ can be, for example, 75° or more and 105° or less.

A size of the angle $\theta_1$ may affect properties of a later-described piezoelectric device module 30. When the angle $\theta_1$ is excessively large, an area of the top surface of the KNN-film 3 may be reduced, and the properties of the piezoelectric device module 30 produced by processing the piezoelectric stack 10 may be degraded, in some cases. On the other hand, when the angle $\theta_1$ is excessively small, an area of a bottom surface of the KNN-film 3 (a surface of the KNN-film 3 opposite to its top surface) may be reduced, and the properties of the piezoelectric device module 30 may be degraded in the similar manner as above, in some cases. From a viewpoint of avoiding the degradation in the properties of the piezoelectric device module 30, the angle $\theta_1$ is preferably within a range of, for example, 75° or more and 105° or less, and more preferably within a range of 85° or more and 100° or less, as described above.

At least a part of the side surface of the KNN-film 3 exposed by etching may be processed to be an inclined surface inclined at a predetermined angle relative to the top surface of the bottom electrode film 2. For example, at least a bottom electrode film 2-side surface of the side surfaces of the KNN-film 3 may be processed to be an inclined surface inclined at an angle of 75° or more and less than 90°, preferably 85° or more and less than 90° relative to the top surface of the bottom electrode film 2.

At least a part of the side surface of the KNN-film 3 exposed by etching may be processed to be perpendicular to the top surface of the bottom electrode film 2. For example, a surface excluding at least the bottom electrode film 2-side surface (i.e., at least a top electrode film 4-side surface) of the side surfaces of the KNN-film 3 may be processed to be perpendicular to the top surface of the bottom electrode film 2.

For example, as illustrated in FIG. 3(d), at least the bottom electrode film 2-side surface of the side surfaces of the KNN-film 3 exposed by etching may be processed to be an inclined surface inclined at an angle of 75° or more and less than 90° relative to the top surface of the bottom electrode film 2, and at least the top electrode film 4-side surface thereof may be processed to be a surface perpendicular to the top surface of the bottom electrode film 2.

The top electrode film 4 can be deposited, for example, using various metals such as Pt, Au, aluminum (Al), or Cu, or an alloy of these various metals. The top electrode film 4 can be deposited by a method such as the sputtering method, the evaporation method, a plating method, or a metal paste method. The top electrode film 4 does not significantly affect the crystal structure of the KNN-film 3, unlike the bottom electrode film 2. Therefore, a material, a crystal structure, and a deposition method of the top electrode film 4 are not particularly limited. An adhesion layer mainly comprising, for example, titanium (Ti), Ta, titanium oxide ($TiO_2$), nickel (Ni), ruthenium oxide ($RuO_2$), iridium oxide ($IrO_2$), or the like may also be provided between the KNN-film 3 and the top electrode film 4 in order to enhance an adhesion between them. A thickness of the top electrode film 4 can be, for example, 100 nm or more and 5000 nm or less. When the adhesion layer is provided, a thickness of the adhesion layer can be, for example, 1 nm or more and 200 nm or less.

The insulating film 5 is provided from the top electrode film 4 to the bottom electrode film 2 to cover a part of the side surface of the KNN-film 3. Details of the insulating film 5 will be described later.

As illustrated in FIG. 1, an adhesion layer 7 enhancing an adhesion between the insulating film 5 and a base of the insulating film 5 may be provided between the insulating film 5 and the base of the insulating film 5. That is, the adhesion layer 7 may be provided from the top electrode film 4 to the bottom electrode film 2 to cover a part of the side surface of the KNN-film 3, and the insulating film 5 may be provided on the adhesion layer 7. The "base of the insulating film 5" in this specification means not only the side surface of the KNN-film 3, but also a surface to be the base of the insulating film 5, among the top surface of the bottom electrode film 2, the top surface of the top electrode film 4, the side surfaces of the top electrode film 4, and the like. The adhesion layer 7 can be provided using a metal oxide (insulating material) with insulating properties. The adhesion layer 7 can be provided using aluminum oxide ($Al_2O_3$), tantalum oxide ($Ta_2O_5$), or the like. The adhesion layer 7 can be provided by a method such as an ALD-method, the sputtering method, or the evaporation method. The adhesion layer 7 does not significantly affect the crystal structure of the KNN-film 3. Therefore, a crystal structure and a deposition method of the adhesion layer 7 are not particularly limited.

A metal wiring 8 with a predetermined pattern, connected to the top electrode film 4, is provided on the insulating film 5. The metal wiring 8 is provided so as not to be connected to (not to be in contact with) the bottom electrode film 2. The metal wiring 8 can be provided using, for example, various metals such as Pt, Au, aluminum (Al), or Cu, or an alloy of these various metals. The metal wiring 8 can be provided by a method such as the sputtering method, the evaporation method, the plating method, or the metal paste method.

A thickness of the metal wiring 8 can be the same as the smallest thickness of a thicknesses $t_1$ of the insulating film 5, defined as the shortest distance from one point on the top surface of the bottom electrode film 2 or on the top surface of the top electrode film 4 (on the top surface of the adhesion layer 7, when the adhesion layer 7 is provided) to a surface of the insulating film 5. Preferably, the thickness of the metal wiring 8 can be thinner than the smallest thickness $t_1$ of the insulating film 5. More preferably, the thickness of the metal wiring 8 can be, for example, 1/20 or more and 1/2 or less, and more preferably 1/20 or more and 1/4 or less of the thickness of the KNN-film 3. In this embodiment, even when the metal wiring 8 is thinner (than in the prior art) in this way, a disconnection of the metal wiring 8 can be avoided because slopes 9a and 9b are provided on the insulating film 5 as described later.

An adhesion layer mainly comprising, for example, Ti, Ta, $TiO_2$, Ni, $RuO_2$, $IrO_2$, or the like may also be provided between the insulating film 5 and the metal wiring 8 in order to enhance an adhesion between them. The adhesion layer can be provided by a method such as the sputtering method or the evaporation method. When the adhesion layer is provided, a thickness of the adhesion layer can be, for example, 1 nm or more and 200 nm or less.

(2) Configuration of insulating film

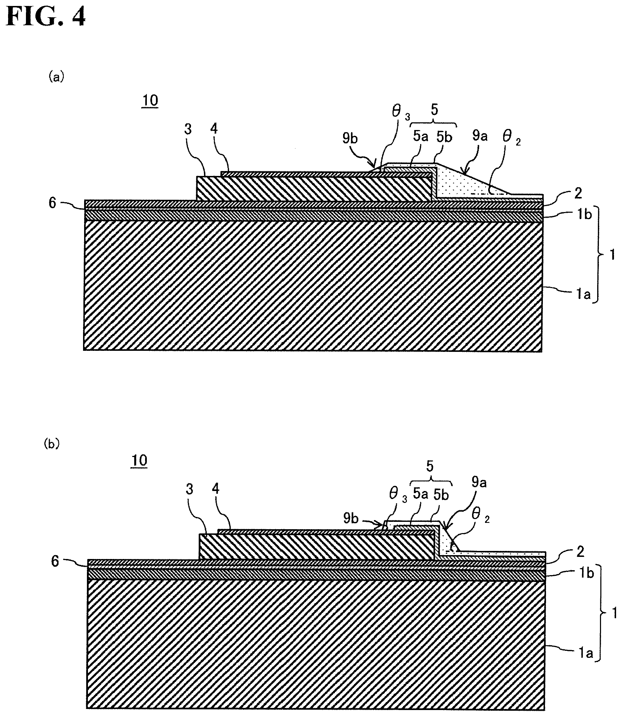

Hereinafter, the insulating film 5 included in the piezoelectric stack 10 will be described in detail with reference to FIGS. 1, 4(a), and 4(b). FIG. 1 illustrates only one example of a thickness $t_2$ of the insulating film 5 in a slope 9a and a thickness $t_3$ of the insulating film 5 in a slope 9b as described later, for the sake of illustration. However, the thickness $t_2$ varies depending on a selected position of one point on the side surface of the KNN-film 3, and the thickness $t_3$ varies depending on a selected position of one point on a surface of the later-described slope 9b. In FIGS. 4(a) and 4(b), the adhesion layer 7 is omitted for ease of understanding.

As illustrated in FIG. 1, the insulating film 5 is provided from the top electrode film 4 to the bottom electrode film 2, preferably from the top surface of the top electrode film 4 to the top surface of the bottom electrode film 2 such that the insulating film 5 is located on the top surface of the top electrode film 4 to partially cover the top surface of the top electrode film 4, to cover a part of the side surface of the KNN film 3.

The insulating film 5 has the slope 9a as a first slope filling a step between the top surface of the top electrode film 4 and the top surface of the bottom electrode film 2. The slope 9a has a shape alleviating the step between the top surface of the top electrode film 4 and the top surface of the bottom electrode film 2. For example, the slope 9a is provided to have its surface non-parallel to the side surface of the KNN-film 3. Also, for example, in a longitudinal section of the slope 9a including the piezoelectric stack 10, the slope 9a is a slope in which the thickness $t_2$ of the insulating film 5, defined as the shortest distance from one point on the side surface of the KNN-film 3 to a surface of the slope 9a in a direction parallel to the top surface of the substrate 1, is gradually increased from the top electrode film 4-side toward the bottom electrode film 2-side. Since such a slope 9a is formed on the insulating film 5, i.e., the insulating film 5 has the slope 9a, the disconnection of the metal wiring 8 can be avoided.

Preferably, the surface of the slope 9a is a surface including a curved surface, thereby making it possible to surely avoid the disconnection of the metal wiring 8. More preferably, the surface of the slope 9a has no step, thereby making it possible to further surely avoid the disconnection of the metal wiring 8.

As illustrated in FIG. 4(a), the smaller an inclination angle $\theta_2$ (hereinafter referred to as angle $\theta_2$) of the slope 9a becomes, i.e., the more acute the angle $\theta_2$, the less likely the metal wiring 8 is to disconnect. However, when the angle $\theta_2$ is excessively small, it becomes difficult to reduce a planar area of the later-described piezoelectric device module 30, and a reduction in the size of the piezoelectric device module 30 cannot be achieved in some cases. On the other hand, as illustrated in FIG. 4(b), the larger the angle $\theta_2$ becomes, i.e., the closer the angle $\theta_2$ is to 90°, the more likely the metal wiring 8 is to disconnect. The angle $\theta_2$ is preferably an angle at which both the reduction in the size of the piezoelectric device module 30 and the avoidance of the disconnection of the metal wiring 8 can be achieved in a good balance.

As illustrated in FIG. 1, the insulating film 5 located on the top surface of the top electrode film 4 has the slope 9b as a second slope in an appearance of not generating a step between the top surface of the insulating film 5 and (the top surface of) the top electrode film 4. The slope 9b has a shape that does not generate the step between the top surface of the insulating film 5 and the top electrode film 4. For example, the slope 9b is provided to have its surface non-parallel to a direction orthogonal to the top surface of the top electrode film 4. Also, for example, the second slope 9b is a slope in which the thickness $t_3$ of the insulating film 5, defined as the shortest distance from one point on a surface of the slope 9b to the top surface of the top electrode film 4, is gradually decreased from an outside of the top surface of the top electrode film 4 toward an inside thereof. Since the insulating film 5 has such a slope 9b, the disconnection of the metal wiring 8 can be surely avoided.

Preferably, the surface of the slope 9b is a surface including a curved surface, thereby making it possible to more surely avoid the disconnection of the metal wiring 8. More preferably, the surface of the slope 9b has no step, thereby making it possible to further surely avoid the disconnection of the metal wiring 8.

As illustrated in FIG. 4(a), the smaller an inclination angle $\theta_3$ (hereinafter referred to as angle $\theta_3$) of the slope 9b becomes, i.e., the more acute the angle $\theta_3$, the less likely the metal wiring 8 is to disconnect. However, when the angle $\theta_3$ is excessively small, it becomes difficult to reduce a planar area of the top electrode film 4, and the reduction in the size of the later-described piezoelectric device module 30 cannot be achieved in some cases. On the other hand, as illustrated in FIG. 4(b), the larger the angle $\theta_3$ becomes, i.e., the closer the angle $\theta_3$ is to 90°, the more likely the metal wiring 8 is to disconnect. The angle $\theta_3$ is preferably an angle at which both the reduction in the size of the piezoelectric device module 30 and the avoidance of the disconnection of the metal wiring 8 can be achieved in a good balance.

As illustrated in FIG. 1, the insulating film 5 has a stack structure in which a first layer 5a and a second layer 5b are stacked in this order from the bottom electrode film 2-side. As described later, the first layer 5a and the second layer 5b are respectively provided by different methods, and even when they comprise the same material, they have slightly different physical properties, such as a density, an impurity concentration, a refractive index, and a step coverage. In the insulating film 5, there are interfaces between the first layer 5a and second layer 5b as traces caused by the above differences.

The first layer 5a is provided with a uniform thickness from (the top surface of) the top electrode film 4 to (the top surface of) the bottom electrode film 2 to cover a part of the side surface of the KNN-film 3.

The first layer 5a comprises an insulating material, for example, a silicon oxide (oxide silicon) such as silicon dioxide ($SiO_2$). The first layer 5a can be formed, e.g., by depositing a vapor-phase (gas-phase) raw material. Silicon hydride gas such as disilane (DS) gas or silane-based gases such as halosilane-based gas (e.g., dichlorosilane (DCS) gas), and oxidizing gas such as oxygen gas, can be used as the vapor-phase (gas-phase) raw materials. Alternatively, alkoxysilane-based gas such as tetraethoxysilane (TEOS) gas can also be used alone as the vapor-phase raw material. The first layer 5a can be formed by a vapor phase deposition method such as the CVD method, the ALD-method, the sputtering method, or a vacuum evaporation method.

The first layer 5a, which comprises the raw material of the vapor-phase deposition, becomes a layer that is denser and excellent in a step coverage, a continuity, and an in-plane thickness uniformity, compared to the later-described second layer 5b. Since the insulating film 5 includes such a first layer 5a, an adhesion between the insulating film 5 and the base (the adhesion layer 7, when the adhesion layer 7 is provided) of the insulating film 5 can be enhanced, which can suppress peeling of the insulating film 5.

A thickness $t_4$ of the first layer 5a is preferably as thick as possible from a viewpoint of surely suppressing peeling of the insulating film 5. However, as described above, the first layer 5a has the properties of high step coverage and excellent in-plane thickness uniformity. Thus, even when the first layer 5a is formed thicker, it is difficult (not realistic) to provide the above-described slopes 9a and 9b (especially the slope 9a) on the insulating film 5. In addition, since the first layer 5a is dense, cracks are more likely to occur due to internal stresses and the like when the first layer 5a is grown thickly. For these reasons, preferably, the thickness $t_4$ of the first layer 5a is a thickness capable of surely suppressing peeling of the insulating film 5, and is a minimum necessary thickness capable of suppressing cracking in the first layer 5a. The thickness $t_4$ of the first layer 5a can be, for example, 200 nm or more and 700 nm or less, preferably 300 nm or more and 600 nm or less, and more preferably 500 nm or more and 600 nm or less. The thickness $t_4$ of the first layer 5a in this specification is a thickness (the smallest thickness), defined as a distance from one point on a bottom surface of the first layer 5a to a surface (top surface) of the first layer 5a in a direction perpendicular to the top surface of the substrate 1 in a region not located above the top electrode film 4 and not located under the slope 9a.

The second layer 5b is provided on the first layer 5a, in an appearance of the above-described slopes 9a and 9b.

The second layer 5b comprises an insulating material, for example, a silicon oxide such as $SiO_2$, similarly to the first layer 5a. The formation of the second layer 5b using the same material as the first layer 5a is preferable because an adhesion between the second layer 5b and the first layer 5a can be enhanced, thus suppressing peeling of the second layer 5b. The second layer 5b can be formed, for example by depositing a liquid-phase raw material. The second layer 5b can be formed, for example, by applying a liquid-phase raw material, which is obtained by dissolving a methylsiloxane-based raw material in a solvent, onto the first layer 5a by a spin coat method, and then solidifying (e.g., drying, calcining) the liquid-phase raw material applied on the first layer 5a. That is, the second layer 5b can be formed by a so-called spin-on-glass (SOG) method.

The second layer 5b, which comprises the raw material of the liquid-phase deposition, has a low in-plane thickness uniformity, and a property that the slopes 9a and 9b are easily formed because the liquid-phase raw material is retained more on a step of the base, compared to the first layer 5a. Since the insulating film 5 includes such a second layer 5b, the slopes 9a and 9b can be easily formed on the insulating film 5, and further the above-described angles $\theta_2$ and $\theta_3$ can be easily adjusted. A thickness $t_5$ of the second layer 5b is preferably a thickness capable of forming the slopes 9a and 9b on the second layer 5b. The thickness $t_5$ of the second layer 5b in this specification is a thickness (the smallest thickness), defined as a distance from one point on a bottom surface of the second layer 5b to a surface of the second layer 5b in a direction perpendicular to the top surface of the substrate 1 in a region not located above the top electrode film 4 and other than a region where the slope 9a is formed. When the thickness $t_5$ of the second layer 5b is excessively thin, the second layer 5b cannot have the slope 9a or 9b, especially the slope 9a, in some cases. The thickness $t_5$ of the second layer 5b can be appropriately set depending on a size (height) of a step where the slope 9a or 9b is provided, i.e., the thickness of the KNN-film 3 and the like. For example, the thickness $t_5$ of the second layer 5b can be thicker than the above-described thickness $t_4$ of the first layer 5a.

(3) Configuration of piezoelectric device module

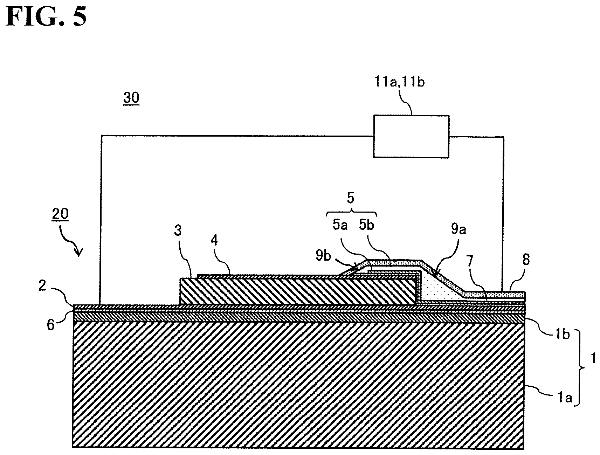

FIG. 5 illustrates a schematic configuration view of a device module 30 (hereinafter also referred to as piezoelectric device module 30) including the KNN-film 3 according to this embodiment. By forming the above-described piezoelectric stack 10 into a predetermined shape, an element (device) 20 (element 20 including the KNN-film 3, hereinafter also referred to as the piezoelectric element 20) is obtained as illustrated in FIG. 5. The piezoelectric device module 30 includes at least the piezoelectric element 20, and a voltage applicator 11 a or a voltage detector 1 1b connected to the piezoelectric element 20. The voltage applicator 11 a is a means that applies a voltage between the bottom electrode film 2 and the top electrode film 4 (between electrodes), and the voltage detector 11b is a means that detects a voltage generated between the bottom electrode film 2 and the top electrode film 4 (between the electrodes). Various known means can be used as the voltage applicator 11a and the voltage detector 11b.

The piezoelectric device module 30 can function as an actuator by connecting the voltage applicator 11a between the bottom electrode film 2 and the top electrode film 4 of the piezoelectric element 20. The KNN-film 3 can be deformed by applying a voltage between the bottom electrode film 2 and the top electrode film 4 using the voltage applicator 11a. Various components connected to the piezoelectric device module 30 can be actuated due to this deformation action. In this case, examples of applications of the piezoelectric device module 30 include heads for inkjet printers, MEMS mirrors for scanners, vibrators for ultrasonic generators, and the like.

The piezoelectric device module 30 can function as a sensor by connecting the voltage detector 11b between the bottom electrode film 2 and the top electrode film 4 of the piezoelectric element 20. When the KNN-film 3 is deformed due to a change in physical quantity of some kind, the deformation generates a voltage between the bottom electrode film 2 and the top electrode film 4. A magnitude of the physical quantity applied to the KNN-film 3 can be measured by detecting the voltage using the voltage detector 11b. In this case, examples of applications of the piezoelectric device module 30 include angular velocity sensors, ultrasonic sensors, pressure sensors, acceleration sensors, and the like.

(4) Method of manufacturing piezoelectric stack, piezoelectric element, and piezoelectric device module

A method of manufacturing the piezoelectric stack 10, the piezoelectric element 20, and the piezoelectric device module 30 will be described.

(Deposition of adhesion layer and bottom electrode film)

The substrate 1 is firstly prepared, and the adhesion layer 6 (Ti-layer) and the bottom electrode film 2 (Pt-film) are deposited in this order on any one of main surfaces of the substrate 1, for example, by the sputtering method. It is also acceptable to prepare the substrate 1 on which the adhesion layer 6 and/or bottom electrode film 2 are deposited in advance on any one of the main surfaces of the substrate 1.

The following conditions are exemplified as the conditions for providing the adhesion layer 6.

Temperature (substrate temperature): 100 °C or higher and 500 °C or lower, preferably 200 °C or higher and 400 °C or lower
RF-power: 1000 W or more and 1500 W or less, preferably 1100 W or more and 1300 W or less
Atmosphere: Argon (Ar) gas atmosphere
Atmosphere pressure: 0.1 Pa or more and 0.5 Pa or less, preferably 0.2 Pa or more and 0.4 Pa or less
Time: 30 seconds or more and 3 minutes or less, preferably 45 seconds or more and 2 minutes or less

The following conditions are exemplified as the conditions for depositing the bottom electrode film 2.

Temperature (substrate temperature): 100 °C or higher and 500 °C or lower, preferably 200 °C or higher and 400 °C or lower
RF-power: 1000 W or more and 1500 W or less, preferably 1100 W or more and 1300 W or less
Atmosphere: Ar-gas atmosphere
Atmosphere pressure: 0.1 Pa or more and 0.5 Pa or less, preferably 0.2 Pa or more and 0.4 Pa or less
Time: 3 minutes or more and 10 minutes or less, preferably 4 minutes or more and 8 minutes or less, more preferably 5 minutes or more and 6 minutes or less

The adhesion layer 6 may be provided using, for example, Ta, $TiO_2$, Ni, $RuO_2$, $IrO_2$, ZnO, or the like, in place of Ti. The bottom electrode film 2 may be deposited using, in place of Ti, various metals such as Au, Ru, or Ir; alloy containing the above various metals as main component; metal oxides such as SRO or LNO; or the like.

(Deposition of KNN-film)

After the deposition of the adhesion layer 6 and the bottom electrode film 2 are finished, the KNN-film 3 is subsequently deposited on the bottom electrode film 2, for example, by the sputtering method. A composition ratio of the KNN-film 3 can be adjusted, for example, by controlling a composition of a target material used during a sputtering deposition. The target material can be prepared by mixing and calcining $K_2CO_3$-powder, $Na_2CO_3$-powder, $Nb_2O_5$-powder, and the like. The composition of the target material can be controlled by adjusting a mixing ratio of the $K_2CO_3$-powder, the $Na_2CO_3$-powder, the $Nb_2O_5$-powder, and the like. When the KNN film 3 comprising an element such as Cu or Mn is to be deposited, the target material may be used in which Cu-powder (or CuO-powder), Mn-powder (or MnO-powder), or the like is mixed at a predetermined ratio in addition to the above each of powders.

The following conditions are exemplified as the conditions for depositing the KNN-film 3. A deposition time can be appropriately set depending on the thickness of the KNN-film 3.

RF-power: 2000 W or more and 2400 W or less, preferably 2100 W or more and 2300 W or less
Atmosphere: Ar-gas + oxygen ($O_2$) gas atmosphere
Atmosphere pressure: 0.2 Pa or more and 0.5 Pa or less, preferably 0.2 Pa or more and 0.4 Pa or less
Partial pressure of Ar-gas relative to $O_2$-gas (Ar/$O_2$-partial pressure ratio): 30/1 to 20/1, preferably 27/1 to 22/1
Deposition temperature: 500 °C or higher and 700 °C or lower, preferably 550 °C or higher and 650 °C or lower
Deposition rate: 0.5 $\mu$m/hr or higher and 2 $\mu$m/hr or lower, preferably 0.5 $\mu$m/hr or higher and 1.5 $\mu$m/hr or lower

(Processing of KNN-film)

After the deposition of the KNN-film 3 is finished, the KNN-film 3 is processed (formed) into a predetermined shape by an etching process such as wet etching using a predetermined etchant (pattern processing of the KNN-film 3).

In the pattern processing of the KNN-film 3 by wet etching, a silicon oxide ($SiO_x$) film or the like is firstly formed on the top surface of the KNN-film 3 as an etching mask for wet etching, for example. Then, wet etching is performed on the KNN-film 3 by immersing the stack including the substrate 1, the adhesion layer 6, the bottom electrode film 2, and the KNN-film 3 in, for example, an etchant comprising an alkaline aqueous solution of a chelating agent and not comprising hydrofluoric acid. An etchant obtained by mixing ethylenediaminetetraacetic acid as the chelating agent, aqueous ammonia, and aqueous hydrogen peroxide, can be used as the etchant comprising the alkaline aqueous solution of the chelating agent and not comprising hydrofluoric acid.

For the material with etching anisotropy like KNN, the shape of the side surface of the KNN-film 3 can be easily controlled by wet etching such that the side surface of the KNN-film 3 is perpendicular to the top surface of the bottom electrode film 2. Alternatively, the shape of the side surface of the KNN-film 3 can be easily controlled such that at least a part of the side surface of the KNN-film 3 is the inclined surface inclined at the angle of, for example, 75° or more and less than 90° relative to the top surface of the bottom electrode film 2. Alternatively, the shape of the side surface of the KNN-film 3 can be easily controlled such that at least a part of the side surface of the KNN-film 3 is the inclined surface inclined at the angle of, for example, more than 90° and 105° or less relative to the top surface of the bottom electrode film 2.

For the material with etching anisotropy like KNN, the shape of the side surface of the KNN-film 3 can also be easily controlled by wet etching such that at least the bottom electrode film 2-side surface of the side surfaces of the KNN-film 3 is the inclined surface inclined at the angle of, for example, 75° or more and less than 90°, preferably 85° or more and less than 90° relative to the top surface of the bottom electrode film 2. Alternatively, the shape of the side surface of the KNN-film 3 can also be easily controlled by wet etching such that a surface excluding at least the bottom electrode film 2-side surface of the side surfaces of the KNN-film 3 is perpendicular to the top surface of the bottom electrode film 2. Alternatively, the shape of the side surface of the KNN-film 3 can also be easily controlled by wet etching such that the bottom electrode film 2-side surface of the side surfaces of the KNN-film 3 is the inclined surface inclined at the angle of, for example, 75° or more and less than 90° relative to the top surface of the bottom electrode film 2 and such that the surface excluding the bottom electrode film 2-side surface of the side surfaces of the KNN-film 3 is perpendicular to the top surface of the bottom electrode film 2.

The pattern processing of the KNN-film 3 may be performed by dry etching such as a reactive-ion etching.

The planar area of the KNN-film 3 becomes smaller than that of the bottom electrode film 2 by the above-described pattern processing.

(Deposition of top electrode film)

After the processing of the KNN-film 3 is finished, the etching mask is removed, and the top electrode film 4 with a predetermined pattern is deposited on (the top surface of) the KNN-film 3, for example, by the sputtering method. Conditions for depositing the top electrode film 4 can be similar to the above-described conditions for depositing the bottom electrode film 2.

(Formation of adhesion layer)

After the deposition of the top electrode film 4 is finished, a mask with a predetermined pattern is formed as needed, and then the adhesion layer 7 ($Al_2O_3$-layer) is provided from the top electrode film 4 to the bottom electrode film 2 to cover a part of the side surface of the KNN-film 3, for example, by the ALD-method.

The following conditions are exemplified as the conditions for providing the adhesion layer 7.

Temperature (substrate temperature): 100 °C or higher and 500 °C or lower, preferably 200 °C or higher and 400 °C or lower
Supplied raw material: trimethylaluminum (($CH_3$)$_3$Al, abbreviated as TMA) and pure water ($H_2O$)
Time: 10 minutes or more and 600 minutes or less, preferably 30 minutes or more and 480 minutes or less, more preferably 60 minutes or more and 150 minutes or less

A $Ta_2O_5$-layer may be provided as the adhesion layer 7, for example.

(Deposition of insulating film)

After the formation of the adhesion layer 7 is finished, the insulating film 5 is deposited on the adhesion layer 7. In a deposition sequence of the insulating film 5, a step of forming the first layer 5a and a step of forming the second layer 5b on the first layer 5a are performed in this order.

<First Layer Formation Step>

In this step, the first layer 5a as a part of the insulating film 5 is provided on the adhesion layer 7 from the top electrode film 4 to the bottom electrode film 2 to cover a part of the side surface of the KNN-film 3. In this step, for example, the first layer 5a is provided by depositing the vapor-phase raw material using a vapor phase deposition method. In this step, for example, the first layer 5a comprising silicon oxide is provided by a plasma CVD method using TEOS-gas.

The following conditions are exemplified as the conditions for forming the first layer 5a.

Temperature (substrate temperature): 200 °C or higher and 500 °C or lower, preferably 300 °C or higher and 400 °C or lower
Supplied raw material: TEOS, oxygen ($O_2$)
RF-power: 50 W or more and 500 W or less, preferably 80 W or more and 300 W or less
Atmospheric pressure: 20 Pa or more and 150 Pa or less, preferably 50 Pa or more and 70 Pa or less
Time: 10 minutes or more and 20 minutes or less

By forming the first layer 5a under the above-described conditions, the first layer 5a can be provided with the uniform thickness from the top electrode film 4 to the bottom electrode film 2 to cover a part of the side surface of the KNN-film 3.

Further, by forming the first layer 5a under the above-described conditions, it is possible to provide the first layer 5a that is denser and excellent in the step coverage, the continuity, and the in-plane thickness uniformity, compared to the second layer 5b. This can surely enhance the adhesion between the first layer 5a and the base of the insulating film 5 (between the first layer 5a and the adhesion layer 7), and can suppress peeling of the insulating film 5. For example, even when unevenness caused by the above-described pattern processing of the KNN-film 3 is formed on the side surface of the KNN-film 3 or the like, peeling of the insulating film 5 (first layer 5a) can be suppressed.

Furthermore, by forming the first layer 5a under the above-described conditions, the thickness of the first layer 5a can be the thickness capable of surely suppressing peeling of the insulating film 5, and the minimum necessary thickness capable of suppressing cracking in the first layer 5a.

<Second Layer Formation Step>

After the first layer formation step is finished, the second layer 5b as a part of the insulating film 5 is provided on the first layer 5a. In this step, the second layer 5b is provided by depositing the liquid-phase raw material. For example, the second layer 5b comprising silicon oxide is provided by applying a liquid-phase raw material, which is obtained by dissolving a methylsiloxane-based raw material in a solvent, onto the first layer 5a using a spin coat method, and then solidifying (e.g., drying, calcining) the liquid-phase raw material. That is, the second layer 5b is provided using a so-called SOG.

The following conditions are exemplified as the conditions for applying the liquid-phase raw material.

Spin coating rotation speed: 1500 rpm or higher and 5000 rpm or lower, preferably 2000 rpm or higher and 4000 rpm or lower, more preferably 2500 rpm or higher and 3500 rpm or lower
Raw material: methylsiloxane-based solution (e.g., OCDT-7 12000T manufactured by TOKYO OHKA KOGYO CO., LTD.)

Solidification (drying, calcining) of the liquid-phase raw material can be performed, for example, by heating a stack applied with the liquid-phase raw material using a hot plate to sufficiently volatilize the solvent of the liquid-phase raw material, and then holding this stack under a nitrogen atmosphere at a predetermined temperature (e.g., 300 °C or higher and 600 °C or lower, preferably 400 °C and higher and 500 °C or lower) for a predetermined time (e.g., 20 minutes or more and 60 minutes or less, preferably 30 minutes or more and 40 minutes or less). The heating using the hot plate can include, for example, a first heating, a second heating, and a third heating, which are performed in this order. In the first heating, the stack is heated for a predetermined time (e.g., 30 seconds or more and 120 seconds or less) with the hot plate adjusted to a predetermined first temperature (e.g., 90 °C or higher and 120 °C or lower). In the second heating, the stack is heated for a predetermined time (e.g., 30 seconds or more and 120 seconds or less) with the hot plate adjusted to a predetermined second temperature (e.g., 140 °C or higher and 170 °C or lower) higher than the first temperature. In the third heating, the stack is heated for a predetermined time (e.g., 30 seconds or more and 120 seconds or less) with the hot plate adjusted to a predetermined third temperature (e.g., 180 °C or higher and 220 °C or lower) higher than the first and second temperatures.

By forming the second layer 5b under the above-described conditions, the second layer 5b having the slope 9a can be provided. Further, by forming the second layer 5b under the above-described conditions, the shape of the slope 9a can be easily controlled such that the above-described step is alleviated. For example, the shape of the slope 9a can be easily controlled such that the surface of the slope 9a is non-parallel to the side surface of the KNN-film 3. Furthermore, for example, the shape of the slope 9a can be easily controlled such that the thickness $t_2$ of the insulating film 5 in the slope 9a is gradually increased from the top electrode film 4-side toward the bottom electrode film 2-side.

Further, by forming the second layer 5b under the above-described conditions, the second layer 5b having the slope 9b can also be provided. Further, by forming the second layer 5b under the above-described conditions, the shape of the slope 9b can be easily controlled. For example, the shape of the slope 9b can be easily controlled such that the surface of the slope 9b is non-parallel to a direction orthogonal to the top surface of the top electrode film 4. Furthermore, for example, the shape of the slope 9b can be easily controlled such that the thickness $t_3$ of the insulating film 5 in the slope 9b is gradually decreased from an outside toward an inside of the top electrode film 4.

Further, by forming the second layer 5b under the above-described conditions, the above-described angles $\theta_2$ and $\theta_3$ can also be easily adjusted.

Furthermore, by forming the second layer 5b under the above-described conditions, the surfaces of the slopes 9a and 9b can be surfaces including curved surfaces, preferably surfaces having no steps.

(Formation of metal wiring)

After the deposition of the insulating film 5 is finished, the predetermined mask is removed in a case where the mask has been formed. Then, the metal wiring 8 is formed on the insulating film 5. In a formation sequence of the metal wiring 8, a step of forming the adhesion layer on the insulating film 5 and a step of forming the metal wiring 8 on the adhesion layer are performed in this order.

<Adhesion Layer Formation Step>

In this step, a mask with a predetermined pattern is formed as needed, and then, for example, a layer comprising Ti as the adhesion layer is provided by an electron beam (EB) evaporation method.
The following conditions are exemplified as the conditions for providing the adhesion layer.

Temperature (substrate temperature): 80 °C or higher and 120 °C or lower, preferably 90 °C or higher and 110 °C or lower
Time: 1 minute or more and 10 minutes or less, preferably 3 minutes or more and 5 minutes or less

The adhesion layer enhancing the adhesion between the insulating film 5 and the metal wiring 8 may be provided using Ta, $TiO_2$, Ni, $RuO_2$, $IrO_2$, or the like, in place of Ti. This adhesion layer can also be provided by a method such as the sputtering method, in place of the EB-evaporation method.

<Metal Wiring Formation Step>

In this step, the metal wiring 8 connected to the top electrode film 4 but not connected to the bottom electrode film 2 is provided on the adhesion layer formed on the insulating film 5. The metal wiring 8 comprising Au is provided by the EB-evaporation method, for example.
The following conditions are exemplified as the conditions for providing the metal wiring 8.

Temperature (substrate temperature): 80 °C or higher and 120 °C or lower, preferably 90 °C or higher and 110 °C or lower
Time: 5 minutes or more and 30 minutes or less, preferably 10 minutes or more and 20 minutes or less

The metal wiring 8 may be provided using, in place of Au, various metals such as Pt, Au, Al, or Cu; or an alloy of these various metals. The metal wiring 8 can also be provided by a method such as the sputtering method, in place of the EB-evaporation method.
After the formation of the metal wiring 8 is finished, the predetermined mask is removed in a case where the mask has been provided. This can produce the piezoelectric stack 10 as illustrated in FIG. 1(a), including the substrate 1, the adhesion layer 6, the bottom electrode film 2 (Pt-film), the KNN-film 3, the top electrode film 4, the adhesion layer 7, the insulating film 5, and the metal wiring 8.

(Production of piezoelectric element and piezoelectric device module)

Subsequently, the insulating film 5 is subjected to a predetermined process, thereby exposing a part of the bottom electrode film 2 and/or forming the piezoelectric stack 10 into a predetermined shape. Thus, the piezoelectric element 20 as illustrated in FIG. 5 can be produced, and the piezoelectric device module 30 can be produced by connecting the voltage applicator 11a or voltage detector 1 1b to the piezoelectric element 20.

(5) Effects

According to the present disclosure, one or more the following effects are obtained.

(a) Since the insulating film 5 has the slope 9a filling the step between the top surface of the top electrode film 4 and the top surface of the bottom electrode film 2, and the slope 9a has the shape alleviating the step, the disconnection of the metal wiring 8 can be avoided. As a result, the reliability of the piezoelectric element 20 and piezoelectric device module 30 can be improved.

(b) Since the insulating film 5 has the slope 9b in the appearance of not generating the step between the top surface of the insulating film 5 and the top electrode film 4, the disconnection of the metal wiring 8 can be surely avoided. As a result, the reliability of the piezoelectric element 20 and piezoelectric device module 30 can be surely improved.

(c) Since the insulating film 5 has the slopes 9a and 9b, the disconnection of the metal wiring 8 can be avoided even when the metal wiring 8 is thinner than that in the prior art. As a result, further reduction in the size and weight and in the manufacturing costs of the piezoelectric device module 30 can also be achieved.

(d) Since the surfaces of the slopes 9a and 9b are the surfaces including curved surfaces, the disconnection of the metal wiring 8 can be surely avoided. Further, since the surfaces of the slopes 9a and 9b have no steps, the disconnection of the metal wiring 8 can be more surely avoided.

(e) Since the side surface of the KNN-film 3 is perpendicular to the top surface of the bottom electrode film 2, at least a part of the side surface of the KNN-film 3 is the inclined surface inclined at the angle of 75° or more and less than 90° relative to the top surface of the bottom electrode film 2, or at least a part of the side surface of the KNN-film 3 is the inclined surface inclined at the angle of more than 90° and 105° or less relative to the top surface of the bottom electrode film 2, the degradation in the properties of the piezoelectric device module 30 can be avoided.

(f) Since the insulating film 5 has a stack structure in which the first layer 5a and the second layer 5b are stacked, peeling of the insulating film 5 can be suppressed while forming the slopes 9a and 9b on the insulating film 5.

(g) Since the first layer 5a and the second layer 5b comprise the same material, the adhesion between the first layer 5a and the second layer 5b can be enhanced, which can surely suppress peeling of the second layer 5b, i.e., peeling of the insulating film 5.

(h) Since the second layer 5b as a part of the insulating film 5 is provided by depositing the liquid-phase raw material, the slopes 9a and 9b can be easily formed on the second layer 5b (insulating film 5), and the above-described angles $\theta_2$ and $\theta_3$ can be easily adjusted.

(i) Since the first layer 5a as a part of the insulating film 5 is provided by depositing the vapor-phase raw material, the first layer 5a becomes a layer that is denser and excellent in the step coverage, the continuity, and the in-plane thickness uniformity, compared to the second layer 5b. Since the insulating film 5 includes such a first layer 5a, the adhesion between the insulating film 5 and the base of the insulating film 5 can be enhanced, which can suppress peeling of the insulating film 5.

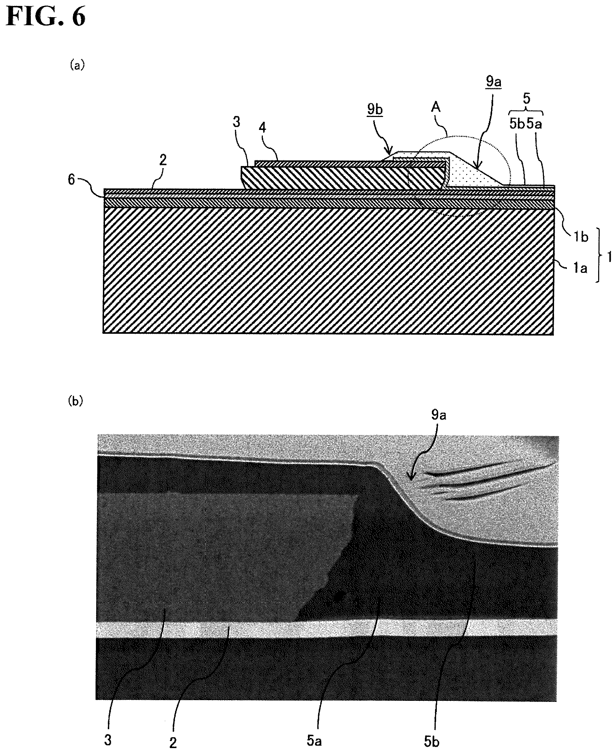

FIG. 6(a) illustrates an example of a cross-sectional structure of the piezoelectric stack according to an embodiment of the present disclosure, and FIG. 6(b) shows an SEM image of an area indicated by a dotted line A in FIG. 6(a). The stack illustrated in FIGS. 6(a) and 6(b) is a stack obtained by providing the bottom electrode film 2 on the substrate 1, providing the KNN-film 3 on the bottom electrode film 2, providing the first layer 5a to cover the surface of the KNN-film 3 and the top surface of the bottom electrode film 2 after performing the pattern processing on the KNN-film 3 by wet etching, and then providing the second layer 5b on the first layer 5a. In other words, the stack illustrated in FIGS. 6(a) and 6(b) does not have the adhesion layer 7 and is a stack before forming the metal wiring 8. From FIG. 6(b), it can be confirmed that the first layer 5a with the excellent step coverage and continuity is provided to have a uniform thickness and the slope 9a can be formed on the insulating film 5 by the second layer 5b, even when at least the bottom electrode film 2-side surface of the side surfaces of the KNN-film 3 exposed by etching is the inclined surface inclined at the angle of 75° or more and less than 90° relative to the top surface of the bottom electrode film 2 while the surface excluding the bottom electrode film 2-side surface of the side surfaces of the KNN-film 3 is perpendicular to the top surface of the bottom electrode film 2.

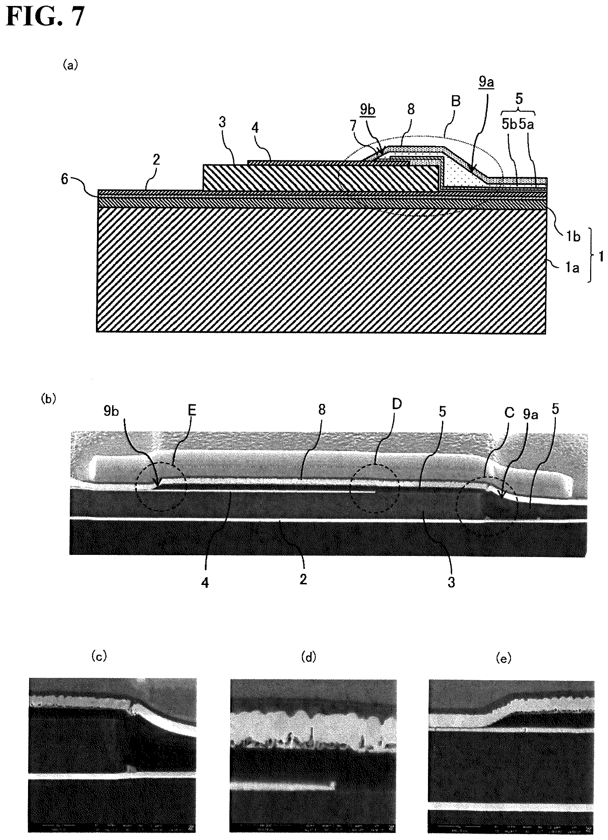

FIG. 7(a) illustrates an example of a cross-sectional structure of the piezoelectric stack according to an embodiment of the present disclosure, FIG.7(b) shows an SEM image of an area indicated by a dotted line B in FIG. 7(a), FIG.7(c) shows an enlarged SEM image of an area indicated by a dotted line C in FIG. 7(b), FIG. 7(d) shows an enlarged SEM image of an area indicated by a dotted line D in FIG. 7(b), and FIG. 7(e) shows an enlarged SEM image of an area indicated by a dotted line E in FIG. 7(b). The piezoelectric stack illustrated in FIGS. 7(b) to 7(e) is produced by providing the bottom electrode film 2, the KNN-film 3, the top electrode film 4, the insulating film 5 (first layer 5a and second layer 5b), and the metal wiring 8 comprising Au, under the conditions described in the above embodiments. From FIGS. 7(b) to 7(e), it can be confirmed that the insulating film 5 can have the slopes 9a and 9b, and that no disconnection occurs in the metal wiring 8, i.e., the disconnection of the metal wiring 8 is avoided.

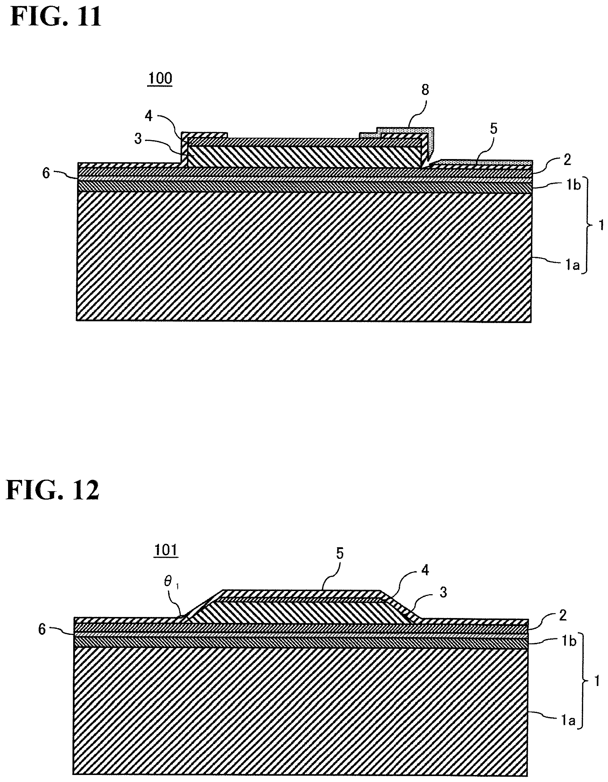

Here, a conventional piezoelectric stack will be described for reference. As in a piezoelectric stack 100 illustrated in FIG. 11, in the conventional piezoelectric stack 100, a step (global step) caused by the step between the top surface of the top electrode film 4 and the top surface of the bottom electrode film 2 is generated on the insulating film 5. Thus, there are problems in which the metal wiring 8 is easily disconnected and the insulating film 5 is easily peeled, at corner formed by the side surface of the KNN-film 3 and the top surface of the bottom electrode film 2, or at corner formed by the top surface and the side surface of the top electrode film 4. In contrast, in this embodiment, the insulating film 5 has the slope 9a filling the step between the top surface of the top electrode film 4 and the top surface of the bottom electrode film 2, and the slope 9a has the shape alleviating the above-described step. This can avoid the disconnection of the metal wiring 8. Further, in this embodiment, since the insulating film 5 has the stack structure in which the first layer 5a and the second layer 5b are stacked, peeling of the insulating film 5 can be suppressed.

In order to avoid the disconnection of the metal wiring 8, it is also conceivable that as in a piezoelectric stack 101 illustrated in FIG. 12, the side surface of the KNN-film 3 is an inclined surface inclined at an angle of more than 105° relative to the top surface of the bottom electrode film 2, i.e., the above-described angle $\theta_1$ is set more than 105° and less than 180°. However, in the piezoelectric stack 101, the area of the top surface of the KNN-film 3 is decreased, thus degrading the properties of the piezoelectric device module 30 produced by processing the piezoelectric stack 101. In contrast, in this embodiment, since the insulating film 5 has the slopes 9a and 9b, the disconnection of the metal wiring 8 can be avoided while avoiding the degradation in the properties of the piezoelectric device module 30 through the avoidance of a decrease of the area of the top surface of the KNN-film 3.

(6) Modified Examples

The present embodiment can be modified to the following modified examples. In the following description of the modified examples, the same reference numerals are given to components that are the same as those in the above embodiments, and descriptions thereof are omitted. The above embodiments and the following modified examples can be arbitrarily combined.

(Modified Example 1)

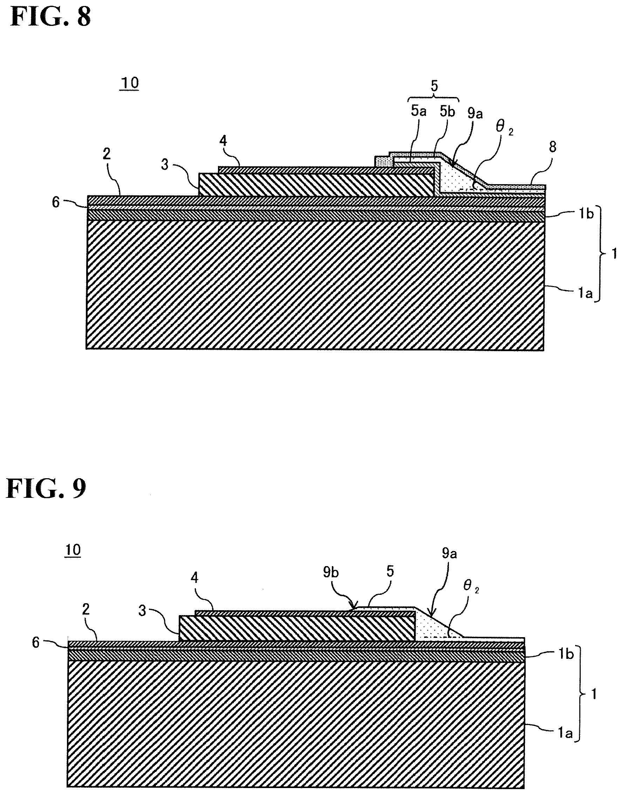

In the above embodiments, an example where the insulating film 5 has the slopes 9a and 9b has been described, but the present disclosure is not limited thereto. For example, as illustrated in FIG. 8, the insulating film 5 only needs to have at least the slope 9a. Even in this modified example, the disconnection of the metal wiring 8 can be avoided, and thus the effects similar to those in the above embodiments can be obtained. However, from a viewpoint of surely avoiding the disconnection of the metal wiring 8, the insulating film 5 preferably has both slopes 9a and 9b.

(Modified Example 2)

In the above embodiments, an example where the insulating film 5 includes the first layer 5a and the second layer 5b has been described, but the present disclosure is not limited thereto. For example, as illustrated in FIG. 9, the insulating film 5 may be a monolayer film. The insulating film 5 of the monolayer film can be provided by the methods and under the conditions similar to that used when providing the above-described second layer 5b. Even in this modified example, since the insulating film 5 has at least the slope 9a, the effects similar to those in the above embodiments can be obtained.

However, from a viewpoint of surely suppressing peeling of the insulating film 5, the insulating film 5 preferably includes the first layer 5a and the second layer 5b. In this modified example, when the insulating film 5 is formed with a thickness capable of forming the slope 9a, an inside of the slope 9a may be brought into a so-called half-baked state due to calcining failure, in some cases. Also from a viewpoint of avoiding such a calcining failure of the insulating film 5, the insulating film 5 preferably includes the first layer 5a and the second layer 5b.

(Modified Example 3)

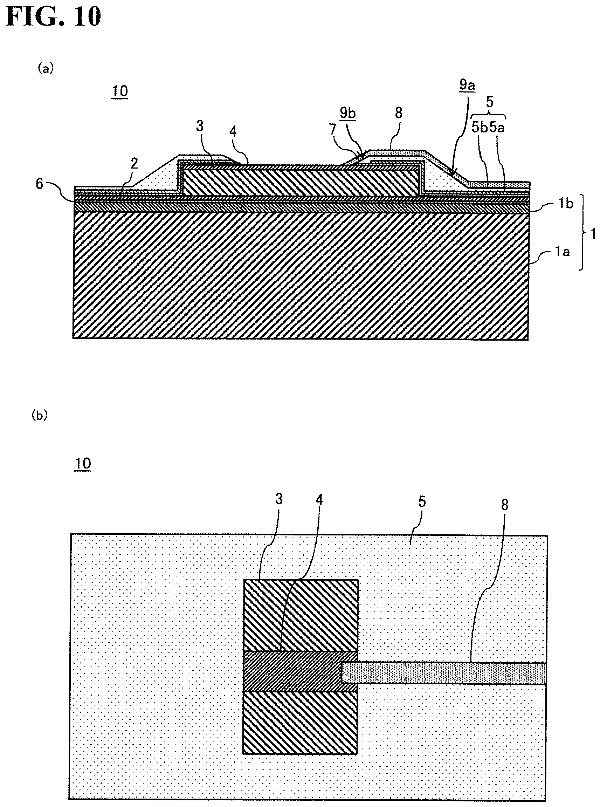

In the above embodiments, an example where the insulating film 5 is provided from the top electrode film 4 to the bottom electrode film 2 to cover a part of the side surface of the KNN-film 3 has been described, but the present disclosure is not limited thereto. The insulating film 5 only needs to be provided from the top electrode film 4 to the bottom electrode film 2 to cover at least a part of the side surface of the KNN-film 3. For example, as illustrated in FIGS. 10(a) and 10(b), the insulating film 5 may be provided from the top electrode film 4 to the bottom electrode film 2 to cover the entire side surfaces of the KNN-film 3. This can surely improve the reliability of the piezoelectric stack 10, the piezoelectric element 20, and the piezoelectric device module 30. However, the insulating film 5 only needs to be provided only at an area(s) requiring insulation.

(Modified Example 4)

In the above embodiments, an example where the deposition of the KNN-film 3, the processing of the KNN-film 3, and the deposition of the top electrode film 4 are performed in this order has been described, but the present disclosure is not limited thereto. The order of these processes may be interchanged as appropriate. For example, the deposition of the KNN-film 3, the deposition of the top electrode film 4, and processing (pattern processing) of the top electrode film 4 and KNN-film 3 may be performed in this order. The pattern processing of the top electrode film 4 can be performed by various known methods.

(Modified Example 5)

In the above embodiments, an example where the piezoelectric stack 10 includes the adhesion layers 6 and 7 has been described, but the present disclosure is not limited thereto. The adhesion layers 6 and 7 may be respectively provided as necessary, and may not be provided when the certain adhesion can be secured without providing the adhesion layers 6 and 7.

(Modified Example 6)

In the above embodiments, an example where the piezoelectric film 3 comprises KNN has been described, but the present disclosure is not limited thereto. The piezoelectric film 3 can be a film comprising a material with etching anisotropy, in place of KNN. For example, the piezoelectric film 3 may be an oxide film (PZT-film) having a perovskite structure and comprising lead, zirconium, titanium, and oxygen, a film (PDMS-film) comprising polydimethylsiloxane, an oxide film (BNT-film) having a perovskite structure and comprising bismuth, sodium, titanium, and oxygen, or an oxide film (bismuth ferrite film) comprising bismuth, iron, and oxygen. Even in this modified example, the effects similar to those in the above embodiments and modified examples can be obtained by including the insulating film 5 with the configurations similar to those in the above embodiments and modified examples.

(Modified Example 7)

In the above embodiments, an example where the piezoelectric stack 10 includes the metal wiring 8 has been described, but the present disclosure is not limited thereto. The stack provided before the metal wiring 8 is provided, can also be considered as the piezoelectric stack 10 and may be distributed in the market without the metal wiring 8.

(Modified Example 8)

For example, an orientation control layer which control an orientation of crystals constituting the KNN-film 3, may be provided between the bottom electrode film 2 and the KNN-film 3, i.e., directly under the KNN-film 3. Note that when the bottom electrode film 2 is not provided, the orientation control layer may be provided between the substrate 1 and the KNN-film 3. The orientation control layer can be formed using a material which is a metal oxide such as SRO, LNO, or strontium titanium oxide ($SrTiO_3$, abbreviated as STO), and which is different from the material of the bottom electrode film 2, for example. The crystals constituting the orientation control layer are preferably preferentially oriented in (100) relative to the main surface of the substrate 1.

(Modified Example 9)

For example, the KNN-film 3 may comprise, in addition to or instead of Cu or Mn, other metallic elements having the effects equivalent to that of Cu or Mn at a predetermined concentration.

(Modified Example 10)

In the above embodiments, an example where one stack structure is formed on one substrate 1 has been described, but the present disclosure is not limited thereto. For example, a plurality of stack structures may be formed on one substrate 1. In this case, each of the plurality of stack structures preferably includes: the bottom electrode film 2; the KNN film 3 provided on the bottom electrode film 2 and having a planar area smaller than a planar area of the bottom electrode film 2; the top electrode film 4 provided on the KNN-film 3; and the insulating film 5 provided from the top electrode film 4 to the bottom electrode film 2 to cover at least a part of the side surface of the KNN-film 3. In addition, the insulating film 5 preferably has at least the above-described slope 9a. The substrate 1 on which one or more stack structure is formed is also referred to as a piezoelectric stacked substrate.

(Modified Example 11)

For example, when forming the above-described piezoelectric stack 10 into the piezoelectric element 20, the substrate 1 may be removed from the piezoelectric stack 10 as long as the piezoelectric device module 30 produced using the piezoelectric stack 10 (piezoelectric element 20) can be used for a desired application such as a sensor or actuator.

<Preferable Aspects of Present Disclosure>

Preferable aspects of the present disclosure will be supplementarily described hereinafter.

(Supplementary description 1)

According to an aspect of the present disclosure, there is provided a piezoelectric stack, including:

a substrate;
a bottom electrode film on the substrate;
a piezoelectric film on the bottom electrode film, having a planar area smaller than a planar area of the bottom electrode film;
a top electrode film on the piezoelectric film; and
an insulating film provided from the top electrode film to the bottom electrode film and covering at least a part of a side surface of the piezoelectric film,
wherein the insulating film has a slope filling a step between a top surface of the top electrode film and a top surface of the bottom electrode film, and
the slope has a shape alleviating the step.

(Supplementary description 2)

Preferably, there is provided the piezoelectric stack according to the supplementary description 1, wherein a surface of the slope is non-parallel to the side surface of the piezoelectric film.

(Supplementary description 3)

Preferably, there is provided the piezoelectric stack according to the supplementary description 1 or 2, wherein in a longitudinal section of the slope including the piezoelectric stack, the slope of the insulating film is a slope in which a thickness ($t_2$) of the insulating film, defined as a shortest distance from one point on the side surface of the piezoelectric film to a surface of the slope in a direction parallel to a top surface of the substrate, is gradually increased from a top electrode film-side toward a bottom electrode film-side.

(Supplementary description 4)

Preferably, there is provided the piezoelectric stack according to any one of the supplementary descriptions 1 to 3,
wherein the surface of the slope is a surface including a curved surface. Preferably, the surface of the slope has no step.

(Supplementary description 5)

Preferably, there is provided the piezoelectric stack according to any one of the supplementary descriptions 1 to 4,

wherein the insulating film is located on the top surface of the top electrode film to partially cover the top surface of the top electrode film, and
the insulating film located on the top surface of the top electrode film has a second slope in an appearance of not generating a step between a top surface of the insulating film and the top electrode film. Preferably, a surface of the second slope is non-parallel to a direction orthogonal to the top surface of the top electrode film.

(Supplementary description 6)

Preferably, there is provided the piezoelectric stack according to the supplementary description 5, wherein the second slope of the insulating film is a slope in which a thickness ($t_3$) of the insulating film, defined as a shortest distance from one point on a surface of the second slope to the top surface of the top electrode film, is gradually decreased from an outside of the top electrode film toward an inside of the top electrode film.

(Supplementary description 7)

Preferably, there is provided the piezoelectric stack according to the supplementary description 5 or 6, wherein the surface of the second slope is a surface including a curved surface. Preferably, the surface of the second slope has no step.

(Supplementary description 8)

Preferably, there is provided the piezoelectric stack according to any one of the supplementary descriptions 1 to 7,
wherein the side surface of the piezoelectric film is perpendicular to the top surface of the bottom electrode film.

(Supplementary description 9)

Preferably, there is provided the piezoelectric stack according to any one of the supplementary descriptions 1 to 7,
wherein at least a part of the side surface of the piezoelectric film is an inclined surface inclined at an angle of 75° or more and less than 90°, preferably 85° or more and less than 90° relative to the top surface of the bottom electrode film, or at an angle of more than 90° and 105° or less, preferably more than 90° and 100° or less relative to the top surface of the bottom electrode film.

(Supplementary description 10)

Preferably, there is provided the piezoelectric stack according to the supplementary description 9, wherein at least a bottom electrode film-side surface of the side surfaces of the piezoelectric film is an inclined surface inclined at an angle of 75° or more and less than 90°, preferably 85° or more and less than 90° relative to the top surface of the bottom electrode film. Preferably, a surface excluding at least the bottom electrode film-side surface of the side surfaces of the piezoelectric film is perpendicular to the top surface of the bottom electrode film.

(Supplementary description 11)

Preferably, there is provided the piezoelectric stack according to any one of the supplementary descriptions 1 to 10, including:
a metal wiring on the insulating film, connected to the top electrode film.

(Supplementary description 12)

Preferably, there is provided the piezoelectric stack according to the supplementary description 11, wherein a thickness of the metal wiring is the same as a smallest thickness of the thicknesses ($t_1$) of the insulating film defined as a shortest distance from one point on the top surface of the bottom electrode film or on the top surface of the top electrode film to the surface of the insulating film, or thinner than the smallest thickness of the insulating film. Preferably, the thickness of the metal wiring is 1/20 or more and 1/2 or less, and preferably 1/20 or more and 1/4 or less of a thickness of the piezoelectric film.

(Supplementary description 13)

Preferably, there is provided the piezoelectric stack according to any one of the supplementary descriptions 1 to 12,
wherein the insulating film includes:

a first layer with a uniform thickness; and

a second layer on the first layer, in an appearance of the slope.

(Supplementary description 14)

Preferably, there is provided the piezoelectric stack according to the supplementary description 13, wherein the first layer comprises a raw material of vapor-phase deposition, and the second layer comprises a liquid-phase raw material. Preferably, the first layer and the second layer differ from each other in density. More preferably, the density of the first layer is higher than that of the second layer.

(Supplementary description 15)

Preferably, there is provided the piezoelectric stack according to the supplementary description 14, wherein a thickness ($t_5$) of the second layer, defined as a distance from one point on a bottom surface of the second layer to a surface of the second layer in a direction perpendicular to the top surface of the substrate in a region not located above the top electrode film and other than a region where the slope is provided, is thicker than a thickness ($t_4$) of the first layer, defined as a distance from one point of a bottom surface of the first layer to a surface of the first layer in a direction perpendicular to the top surface of the substrate in a region not located above the top electrode film and not located under the slope.

(Supplementary description 16)

Preferably, there is provided the piezoelectric stack according to any one of the supplementary descriptions 13 to 15,
wherein the first layer and the second layer comprise the same material.

(Supplementary description 17)

Preferably, there is provided the piezoelectric stack according to the supplementary description 16, wherein both the first layer and the second layer comprise silicon oxide.

(Supplementary description 18)

Preferably, there is provided the piezoelectric stack according to any one of the supplementary descriptions 13 to 17,

wherein the first layer is a layer of vapor phase deposition (such as CVD, ALD, sputtering, or vacuum evaporation), and the second layer is a layer comprising a solidified (e.g., dried or calcined) raw material of liquid phase deposition (e.g., spin coated) on the first layer.

(Supplementary description 19)

Preferably, there is provided the piezoelectric stack according to any one of the supplementary descriptions 1 to 18, including:
an adhesion layer between the insulating film and a base (the top electrode film, the piezoelectric film, and the bottom electrode film) of the insulating film, the adhesion layer enhancing adhesion between the insulating film and the base.

(Supplementary description 20)

Preferably, there is provided the piezoelectric stack according to the supplementary description 19, wherein the adhesion layer comprises a metal oxide (insulating material) with insulating properties. Preferably, the adhesion layer comprises either aluminum oxide ($Al_2O_3$) or tantalum oxide ($Ta_2O_5$).

(Supplementary description 21)

Preferably, there is provided the piezoelectric stack according to any one of the supplementary descriptions 1 to 20,
wherein the piezoelectric film comprises a material with etching anisotropy.

(Supplementary description 22)

Preferably, there is provided the piezoelectric stack according to any one of the supplementary descriptions 1 to 21,
wherein the piezoelectric film is an alkali niobium oxide film having a perovskite structure and comprising potassium, sodium, niobium, and oxygen.

(Supplementary description 23)

According to another aspect of the present disclosure, there is provided a piezoelectric element, including:

a substrate;
a bottom electrode film on the substrate;
a piezoelectric film on the bottom electrode film, having a planar area smaller than a planar area of the bottom electrode film;
a top electrode film on the piezoelectric film; and
an insulating film provided from the top electrode film to the bottom electrode film and covering at least a part of a side surface of the piezoelectric film,
wherein the insulating film has a slope filling a step between a top surface of the top electrode film and a top surface of the bottom electrode film, and
the slope has a shape alleviating the step.

(Supplementary description 24)

According to a further aspect of the present disclosure, there is provided a piezoelectric stacked substrate, including a plurality of stack structures on one substrate,
the plurality of stack structures, each including:

a bottom electrode film;
a piezoelectric film on the bottom electrode film, having a planar area smaller than a planar area of the bottom electrode film;
a top electrode film on the piezoelectric film; and
an insulating film provided from the top electrode film to the bottom electrode film and covering at least a part of a side surface of the piezoelectric film,
wherein the insulating film has a slope filling a step between a top surface of the top electrode film and a top surface of the bottom electrode film, and the slope has a shape alleviating the step.

(Supplementary description 25)

According to a still further aspect of the present disclosure, there is provided a method of manufacturing a piezoelectric stack, including:

providing a bottom electrode film on a substrate;
providing a piezoelectric film on the bottom electrode film;
processing the piezoelectric film into a predetermined shape;
providing a top electrode film on the piezoelectric film; and
providing an insulating film from the top electrode film to the bottom electrode film to cover at least a part of a side surface of the piezoelectric film,
wherein in the providing of the insulating film,
a slope filling a step between a top surface of the top electrode film and a top surface of the bottom electrode film is formed in the insulating film, and
a shape of the slope is controlled such that the step is alleviated.

(Supplementary description 26)

Preferably, there is provided the method according to the supplementary description 25,
wherein in the providing of the insulating film, the shape of the slope is controlled such that a thickness ($t_2$) of the insulating film, defined as a shortest distance from one point on the side surface of the piezoelectric film to a surface of the slope in a direction parallel to a top surface of the substrate, is gradually increased from a top electrode film-side toward a bottom electrode film-side, in a longitudinal section of the slope including the piezoelectric stack.

(Supplementary description 27)

Preferably, there is provided the method according to the supplementary description 25 or 26,

wherein in the providing of the insulating film,
a second slope having no step between a top surface of the insulating film and the top electrode film is further formed in the insulating film.

(Supplementary description 28)

Preferably, there is provided the method according to any one of the supplementary descriptions 25 to 27,

wherein in the processing of the piezoelectric film,
a shape of the side surface of the piezoelectric film is controlled such that the side surface of the piezoelectric film is perpendicular to the top surface of the bottom electrode film.

(Supplementary description 29)

Preferably, there is provided the method according to any one of the supplementary descriptions 25 to 27,

wherein in the processing of the piezoelectric film,
a shape of the side surface of the piezoelectric film is controlled such that at least a part of the side surface of the piezoelectric film is an inclined surface inclined at an angle of 75° or more and less than 90°, preferably 85° or more and less than 90° relative to the top surface of the bottom electrode film, or an inclined surface inclined at an angle of more than 90° and 105° or less, preferably more than 90° and 100° or less relative to the top surface of the bottom electrode film.

(Supplementary description 30)

Preferably, there is provided the method according to the supplementary description 29, wherein in the processing of the piezoelectric film, the shape of the side surface of the piezoelectric film is controlled such that at least a bottom electrode film-side surface of the side surfaces of the piezoelectric film is the inclined surface inclined at an angle of 75° or more and less than 90°, preferably 85° or more and less than 90° relative to the top surface of the bottom electrode film. Preferably, in the processing of the piezoelectric film, the shape of the side surface of the piezoelectric film is controlled such that a surface excluding at least the bottom electrode film-side surface of the side surfaces of the piezoelectric film is perpendicular to the top surface of the bottom electrode film.

(Supplementary description 31)

Preferably, there is provided the method according to any one of the supplementary descriptions 25 to 30, providing, on the insulating film, a metal wiring to be connected to the top electrode film.

(Supplementary description 32)

Preferably, there is provided the method according to any one of the supplementary descriptions 25 to 31, wherein in the providing of the insulating film, at least a part of the insulating film is provided by depositing a liquid-phase raw material.

(Supplementary description 33)

Preferably, there is provided the method according to any one of the supplementary descriptions 25 to 32, wherein in the providing of the insulating film, at least a part of the insulating film is provided by depositing a vapor-phase raw material.

(Supplementary description 34)

Preferably, there is provided the method according to any one of the supplementary descriptions 25 to 33,

wherein in the providing of the insulating film,
a first layer with a uniform thickness is provided as a part of the insulating film from the top electrode film to the bottom electrode film to cover at least a part of the side surface of the piezoelectric film, and
a second layer having the slope is provided on the first layer as a part of the insulating film.

(Supplementary description 35)

Preferably, there is provided the method according to any one of the supplementary descriptions 25 to 34,

wherein in the providing of the insulating film, the first layer is provided by a vapor-phase raw material using a vapor phase deposition method (such as a CVD method, an ALD method, a sputtering method, or a vacuum evaporation method),
and

the second layer is provided by applying a liquid-phase raw material on the first layer (e.g., using a spin coating method) and solidifying (drying and firing) the liquid-phase raw material.

(Supplementary description 36)

Preferably, there is provided the method according to any one of the supplementary descriptions 25 to 35, further including:

providing an adhesion layer enhancing adhesion between the insulating film and a base of the insulating film,
wherein the providing of the adhesion layer is performed after the providing of the top electrode film and before the providing of the insulating film.

DESCRIPTION OF SIGNS AND NUMERALS

1       Substrate
2       Bottom electrode film
3       Piezoelectric film (KNN-film)
4       Top electrode film
5       Insulating film
5a      First layer
5b      Second layer
9a, 9b  Slope
10      Piezoelectric stack

**Claims**

1. A piezoelectric stack, comprising:

a substrate;
a bottom electrode film on the substrate;
a piezoelectric film on the bottom electrode film, having a planar area smaller than a planar area of the bottom electrode film;
a top electrode film on the piezoelectric film; and
an insulating film provided from the top electrode film to the bottom electrode film and covering at least a part of a side surface of the piezoelectric film,
wherein the insulating film has a slope filling a step between a top surface of the top electrode film and a top surface of the bottom electrode film, and

the slope has a shape alleviating the step.

2. The piezoelectric stack according to claim 1, wherein in a longitudinal section of the slope including the piezoelectric stack, the slope of the insulating film is a slope in which a thickness of the insulating film, defined as a shortest distance from one point on the side surface of the piezoelectric film to a surface of the slope in a direction parallel to a top surface of the substrate, is gradually increased from a top electrode film-side toward a bottom electrode film-side.

3. The piezoelectric stack according to claim 1 or 2, wherein the side surface of the piezoelectric film is perpendicular to the top surface of the bottom electrode film.

4. The piezoelectric stack according to claim 1 or 2, wherein at least a bottom electrode film-side surface of the side surfaces of the piezoelectric film is an inclined surface inclined at an angle of 75° or more and less than 90° relative to the top surface of the bottom electrode film.

5. The piezoelectric stack according to claim 4, wherein a surface excluding at least the bottom electrode film-side surface of the side surfaces of the piezoelectric film is perpendicular to the top surface of the bottom electrode film.

6. The piezoelectric stack according to any one of claims 1 to 5, comprising: a metal wiring on the insulating film, connected to the top electrode film.

7. The piezoelectric stack according to any one of claims 1 to 6,
wherein the insulating film comprises:

   a first layer with a uniform thickness; and
   a second layer on the first layer, in appearance of the slope.

8. The piezoelectric stack according to claim 7,

   wherein the first layer comprises a raw material of vapor phase deposition, and
   the second layer comprises a raw material of liquid phase deposition.

9. The piezoelectric stack according to claim 7 or 8, wherein both the first layer and the second layer comprise silicon oxide.

10. The piezoelectric stack according to any one of claims 1 to 9, comprising an adhesion layer between the insulating film and a base of the insulating film, the adhesion layer enhancing adhesion between the insulating film and the base.

11. The piezoelectric stack according to any one of claims 1 to 10, wherein the piezoelectric film is an alkali niobium oxide film having a perovskite structure and comprising potassium, sodium, niobium, and oxygen.

12. A piezoelectric element, comprising:

   a substrate;
   a bottom electrode film on the substrate;
   a piezoelectric film on the bottom electrode film, having a planar area smaller than a planar area of the bottom electrode film;
   a top electrode film on the piezoelectric film; and
   an insulating film provided from the top electrode film to the bottom electrode film and covering at least a part of a side surface of the piezoelectric film,
   wherein the insulating film has a slope filling a step between a top surface of the top electrode film and a top surface of the bottom electrode film, and
   the slope has a shape alleviating the step.

13. A method of manufacturing a piezoelectric stack, comprising:

   providing a bottom electrode film on a substrate;
   providing a piezoelectric film on the bottom electrode film;

processing the piezoelectric film into a predetermined shape;
providing a top electrode film on the piezoelectric film; and
providing an insulating film from the top electrode film to the bottom electrode film to cover at least a part of a side surface of the piezoelectric film,
wherein in the providing of the insulating film,
a slope filling a step between a top surface of the top electrode film and a top surface of the bottom electrode film is formed in the insulating film, and
a shape of the slope is controlled such that the step is alleviated.

14. The method of manufacturing a piezoelectric stack according to claim 13, wherein in the providing of the insulating film, at least a part of the insulating film is provided by depositing a liquid-phase raw material.

15. The method of manufacturing a piezoelectric stack according to claim 13 or 14,

wherein in the providing of the insulating film,
a first layer with a uniform thickness is provided as a part of the insulating film from the top electrode film to the bottom electrode film to cover at least a part of the side surface of the piezoelectric film, and
a second layer having the slope is provided on the first layer as a part of the insulating film.

16. The method of manufacturing a piezoelectric stack according to claim 15,

wherein in the providing of the insulating film,
the first layer is provided by depositing a vapor-phase raw material using a vapor phase deposition method, and
the second layer is provided by applying a liquid-phase raw material on the first layer and solidifying the liquid-phase raw material.

17. The method of manufacturing a piezoelectric stack according to any one of claims 13 to 16, further comprising:
providing an adhesion layer enhancing adhesion between the insulating film and a base of the insulating film,
wherein the providing of the adhesion layer is performed after the providing of the top electrode film and before the providing of the insulating film.

# FIG. 1

(a)

(b)

FIG. 2

# FIG. 3

(a)

(b)

(c)

(d)

# FIG. 4

(a)

(b)

FIG. 5

# FIG. 6

(a)

(b)

# FIG. 7

(a)

(b)

(c)

(d)

(e)

**FIG. 8**

**FIG. 9**

# FIG. 10

(a)

(b)

**FIG. 11**

**FIG. 12**

## INTERNATIONAL SEARCH REPORT

International application No.

**PCT/JP2022/000632**

### A. CLASSIFICATION OF SUBJECT MATTER

*H01L 41/047*(2006.01)i; *H01L 41/053*(2006.01)i; *H01L 41/09*(2006.01)i; *H01L 41/113*(2006.01)i; *H01L 41/187*(2006.01)i; *H01L 41/23*(2013.01)i; *H01L 41/29*(2013.01)i
FI:  H01L41/047; H01L41/053; H01L41/09; H01L41/113; H01L41/187; H01L41/23; H01L41/29

According to International Patent Classification (IPC) or to both national classification and IPC

### B. FIELDS SEARCHED

Minimum documentation searched (classification system followed by classification symbols)

H01L41/047; H01L41/053; H01L41/09; H01L41/113; H01L41/187; H01L41/23; H01L41/29; B41J2/16; H03H9/15; H04R17/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | EP 3742506 A1 (STMICROELECTRONICS S. R. L.) 25 November 2020 (2020-11-25) paragraphs [0001]-[0013], fig. 1A-1D | 1-6, 10, 12, 13, 17 |
| Y | paragraphs [0001]-[0013], fig. 1A-1D | 11 |
| A | paragraphs [0001]-[0013], fig. 1A-1D | 7-9, 14-16 |
| Y | JP 2008-159807 A (HITACHI CABLE, LTD.) 10 July 2008 (2008-07-10) paragraph [0006] | 11 |
| A | JP 2008-11483 A (KYOCERA CORP.) 17 January 2008 (2008-01-17) entire text, all drawings | 1-17 |
| A | JP 2015-220399 A (RICOH CO., LTD.) 07 December 2015 (2015-12-07) entire text, all drawings | 1-17 |
| A | JP 2018-164039 A (SEIKO EPSON CORP.) 18 October 2018 (2018-10-18) entire text, all drawings | 1-17 |

☑ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **24 March 2022** | **05 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

EP 4 293 735 A1

**INTERNATIONAL SEARCH REPORT**

| International application No. |
| --- |
| **PCT/JP2022/000632** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2020/0369029 A1 (ASSANELLI et al.) 26 November 2020 (2020-11-26)<br>entire text, all drawings | 1-17 |

Form PCT/ISA/210 (second sheet) (January 2015)

**INTERNATIONAL SEARCH REPORT**
**Information on patent family members**

International application No.

**PCT/JP2022/000632**

| Patent document cited in search report | | | Publication date (day/month/year) | Patent family member(s) | | | Publication date (day/month/year) |
|---|---|---|---|---|---|---|---|
| EP | 3742506 | A1 | 25 November 2020 | US 2020/369029 A1 paragraphs [0003]-[0014], fig. 1A-1D CN 111987213 A | | | |
| JP | 2008-159807 | A | 10 July 2008 | US 2009/0236944 A1 paragraph [0009] | | | |
| JP | 2008-11483 | A | 17 January 2008 | (Family: none) | | | |
| JP | 2015-220399 | A | 07 December 2015 | (Family: none) | | | |
| JP | 2018-164039 | A | 18 October 2018 | US 2018/0277738 A1 entire text, all drawings EP 3385996 A1 CN 108666413 A | | | |
| US | 2020/0369029 | A1 | 26 November 2020 | (Family: none) | | | |

Form PCT/ISA/210 (patent family annex) (January 2015)

**REFERENCES CITED IN THE DESCRIPTION**

**Patent documents cited in the description**

- JP 2007184513 A

- JP 2008159807 A